# EUROPÄISCHE PATENTSCHRIFT

(11) **EP 4 562 667 B1**
(45) Veröffentlichungstag und Bekanntmachung des Hinweises auf die Patenterteilung: **20.05.2026**
(21) Anmeldenummer: 23750954.2
(22) Anmeldetag: 27.07.2023
(51) Int. Cl.: H01J 37/32, H03H 7/40

(54) **STEUERUNGSVORRICHTUNG UND VERFAHREN ZUR ANSTEUERUNG EINER IMPEDANZANPASSUNGSSCHALTUNG FÜR EIN PLASMAERZEUGUNGSSYSTEM SOWIE EIN SOLCHES PLASMAERZEUGUNGSSYSTEM**
CONTROL DEVICE AND METHOD FOR ACTUATING AN IMPEDANCE-MATCHING CIRCUIT FOR A PLASMA PRODUCTION SYSTEM AND PLASMA PRODUCTION SYSTEM OF THIS KIND
DISPOSITIF DE COMMANDE ET PROCÉDÉ D'ACTIONNEMENT DE CIRCUIT D'ADAPTATION D'IMPÉDANCE POUR UN SYSTÈME DE PRODUCTION DE PLASMA ET SYSTÈME DE PRODUCTION DE PLASMA DE CE TYPE

(30) Priorität: 29.07.2022 DE 102022119157
(43) Veröffentlichungstag der Anmeldung: 04.06.2025
(73) Patentinhaber: TRUMPF Hüttinger GmbH + Co. KG, 79111 Freiburg (DE)
(72) Erfinder: MAIER, Florian, 79292 Pfaffenweiler (DE)
(74) Vertreter: Trumpf Patentabteilung
(86) Internationale Anmeldenummer: PCT/EP2023/070886
(87) Internationale Veröffentlichungsnummer: WO 2024/023244

(56) Entgegenhaltungen:
- US-A1- 2016 322 207
- US-A1- 2019 272 306
- US-A1- 2022 139 674
- US-B1- 6 291 999

## Beschreibung

Die Erfindung betrifft eine Steuerungsvorrichtung zur Ansteuerung einer Impedanzanpassungsschaltung für ein Plasmaerzeugungssystem, ein Verfahren zur Ansteuerung einer Impedanzanpassungsschaltung für ein Plasmaerzeugungssystem und ein solches Plasmaerzeugungssystem mit einer solchen Steuerungsvorrichtung.

Die Oberflächenbehandlung von Werkstücken mit Hilfe von Plasma sowie Gaslaser sind industrielle Verfahren, bei denen, insbesondere in einer Plasmakammer, ein Plasma mit Gleichstrom oder mit einem hochfrequenten Wechselsignal mit einer Arbeitsfrequenz im Bereich von einigen 10 kHz bis in den GHz-Bereich erzeugt wird.

Die Plasmakammer kann dabei über weitere elektronische Bauteile, wie Spulen, Kondensatoren, Leitungen oder Transformatoren, an einen Hochfrequenzgenerator (HF-Generator) angeschlossen sein. Diese weiteren Bauteile können als Schwingkreis, Filter oder Impedanzanpassung wirken.

Der Plasmaprozess hat das Problem, dass die elektrische Lastimpedanz des Plasmas in der Plasmakammer, die während des Prozesses auftritt, von den Zuständen in der Plasmakammer abhängt und stark variieren kann. Insbesondere gehen die Eigenschaften von Werkstück, Elektroden und Gasverhältnissen ein. Die Besonderheit bei solchen stark variierenden Lasten kann dabei auch darin bestehen, dass diese Laständerungen schneller erfolgen als eine geregelte Impedanzanpassung eine Lastanpassung vornehmen kann. Insbesondere kann eine Laständerung auch innerhalb einer Periode der Grundwelle, also des HF-Leistungssignals erfolgen, das das Plasma betreibt. Dann wird nicht nur Leistung bei der Grundwelle reflektiert, sondern zusätzlich auch noch Leistungsanteile bei Oberwellen, den sogenannten Harmonischen.

Hochfrequenzgeneratoren weisen einen eingeschränkten Arbeitsbereich bezüglich der Impedanz der angeschlossenen elektrischen Last (= Verbraucher) auf. Verlässt die Lastimpedanz einen zulässigen Bereich, kann es zu einer Beschädigung oder gar Zerstörung des HF-Generators kommen. Grund dafür ist in den meisten Fällen diese reflektierte Leistung, die den Generator schädigen kann, wenn **z.B.** die reflektierte Leistung, die Spannung oder die reflektierte Energie für den HF-Generator zu groß wird.

Aus diesem Grund ist in der Regel eine Impedanzanpassungsschaltung (Matchbox) erforderlich, die die Impedanz der Last auf eine Nennimpedanz des Generatorausgangs transformiert.

Es sind unterschiedliche Impedanzanpassungsschaltungen bekannt. Entweder sind die Impedanzanpassungsschaltungen fest eingestellt und haben eine vorgegebene Transformationswirkung, bestehen also aus elektrischen Bauelementen, insbesondere Spulen und Kondensatoren, die während des Betriebes nicht verändert werden. Dies ist insbesondere bei immer gleichbleibendem Betrieb, wie z. B. bei einem Gaslaser, sinnvoll. Weiterhin sind Impedanzanpassungsschaltungen bekannt, bei denen zumindest ein Teil der Bauelemente der Impedanzanpassungsschaltungen mechanisch veränderlich sind. Beispielsweise sind motorbetriebene Drehkondensatoren bekannt, deren Kapazitätswert verändert werden kann, indem die Anordnung der Kondensatorplatten relativ zueinander verändert wird.

Einem Plasma können bei grober Betrachtung drei Impedanzbereiche zugeordnet werden. Vor der Zündung liegen Impedanzen mit relativ hohem Realteil vor. Im Normalbetrieb, d. h. bei bestimmungsgemäßem Betrieb mit Plasma, liegen Impedanzen mit relativ niedrigerem Realteil vor. Bei unerwünschten lokalen Entladungen (Arcs) oder bei Plasmaschwankungen können relativ kleine Impedanzwerte auftreten. Außer diesen drei identifizierten Impedanzbereichen können noch weitere Sonderzustände mit anderen zugeordneten Impedanzwerten auftreten. Verändert sich die Lastimpedanz schlagartig und gelangt dabei die Lastimpedanz und damit auch die transformierte Lastimpedanz aus einem zulässigen Impedanzbereich, können der HF-Generator oder auch Übertragungseinrichtungen zwischen dem HF-Generator und der Plasmakammer beschädigt werden. Es gibt außerdem auch stabile Zustände des Plasmas die nicht erwünscht sind. So kann sich z.B. in einer Plasmakammer ein stabiles Plasma in einem Bereich bilden, in dem dieses gar nicht erwünscht ist, z.B. in einem Randbereich anstatt an dem Target.

Eine Impedanzanpassungsschaltung ist beispielsweise in der DE 10 2009 001 355 A1 beschrieben.

In US 2019/272306 A1 sind Systeme und Verfahren zur schrittweisen Abstimmung eines Impedanzanpassungsnetzwerks beschrieben. Durch die schrittweise Abstimmung des Impedanzanpassungsnetzwerks statt direkt auf das Erreichen optimaler Werte einer Hochfrequenz und einer kombinierten variablen Kapazität wird die Bearbeitung eines Wafers mit den abgestimmten optimalen Werten möglich.

In US 2022/139674 A1 ist ein Stromversorgungssystem für ein Plasmaprozesssystem und die zugehörigen Verfahren beschrieben. Das Stromversorgungssystem umfasst einen Generator mit einem Frequenzabstimmungs-Subsystem, einem Match-Netzwerk, das zwischen der Plasmaverarbeitungskammer und dem Generator gekoppelt ist, und ein Mittel zum Einstellen einer Impedanz des Match-Netzwerks, so dass das Frequenzabstimmungs-Subsystem eine Frequenz der vom Generator angelegten Leistung an eine Zielfrequenz anpasst, während das Match-Netzwerk dem Generator eine gewünschte Impedanz als Reaktion auf Variationen in der Impedanz eines Plasmas in einer Plasmaprozesskammer präsentiert.

In US 2016/322207 A1 sind Systeme und Methoden zur Verwendung mehrerer Vorrichtungen und der Effizienz zur Bestimmung fester Parameter eines übereinstimmenden Netzwerkmodells beschrieben. Es werden ein Effizienzwert, der mit einem Netzwerkanalysator gemessen wird, und ein Wert der vorhergesagten Effizienz, der mit dem entsprechenden Netzwerkmodell bestimmt wird, verglichen. Durch den Vergleich wird ermittelt, ob die festen Parameter dem passenden Netzmodell zugeordnet werden sollen.

In US 6 291 999 B1 ist eine Plasmaüberwachungsvorrichtung zum Überwachen des Plasmazustands einer Plasmalast, der Strom von einer Hochfrequenzstromquelle über eine Impedanzanpassung zugeführt wird, beschrieben. Dabei erfolgen mehrere Berechnungen von Impedanzen an Ein- und Ausgang der Impedanzanpassung.

Es ist auch bekannt, dass Plasmaprozesse relativ hohe Leistung, oftmals ein oder mehrere kW, und/oder Energie benötigen, was heutzutage eine immer größere Rolle spielt.

Ein HF-Generator und eine Impedanzanpassungsschaltung arbeiten jeweils abhängig von mehreren Parametern mit veränderlichem Wirkungsgrad. Bei immer größer werdender Leistung und/oder Energie im Plasmaprozess spielt der Wirkungsgrad eine immer größere Rolle.

Es ist daher die Aufgabe der hier vorliegenden Erfindung, einen verlustarmen, energiesparsamen Plasmaprozess zu etablieren.

Die Aufgabe wird durch die erfindungsgemäße Steuerungsvorrichtung gemäß dem unabhängigen Anspruch 1, sowie durch das erfindungsgemäße Plasmaerzeugungssystem gemäß dem unabhängigen Anspruch 16, sowie durch das Verfahren gemäß dem unabhängigen Anspruch 29 gelöst.

Die Steuerungsvorrichtung dient zur Ansteuerung einer Impedanzanpassungsschaltung für ein Plasmaerzeugungssystem. Die Impedanzanpassungsschaltung umfasst einen Eingangsanschluss und einen Ausgangsanschluss und ist zwischen einem HF-Generator und einer Last anschließbar. Bei der Last kann es sich insbesondere um zumindest eine Elektrode, an welcher ein Plasma, insbesondere in einer Plasmakammer, erzeugt wird, handeln.

Die Steuerungsvorrichtung ist dazu ausgebildet, um anhand von:
a) einer vorgebbaren Betriebsfrequenz des HF-Generators;
b) einer vorgebbaren Zielleistung des HF-Generators; und
c) Modellparametern des HF-Generators;
einen Impedanzzielwert für den Eingangsanschluss der Impedanzanpassungsschaltung zu ermitteln, wobei der Impedanzzielwert einen von einer Nennimpedanz des HF-Generators abweichenden Wert aufweist, um dadurch eine Erhöhung eines Betriebskennwerts des HF-Generators für die vorgebbare Betriebsfrequenz und die vorgebbare Zielleistung zu erreichen. Bei dem Betriebskennwert des HF-Generators handelt es sich bevorzugt um die Effizienz des HF-Generators. Dabei kann die Steuerungsvorrichtung dazu ausgebildet sein, die vorgebbare Betriebsfrequenz, die vorgebbare Zielleistung und die Modellparameter des HF-Generators geliefert zu bekommen und/oder intern gespeichert zu haben und/oder auf andere Weise Zugang dazu zu haben. So kann sie diese z.B. über eine Schnittstelle, z.B. eine elektronische Datenschnittstelle, übermittelt bekommen. Sie kann sie z.B. in einem internen elektronischen Datenspeicher abgelegt haben. Sie kann sie z.B. selbst aus anderen Quellen oder Daten oder einer Kombination daraus ermitteln.

Es ist besonders bevorzugt, dass der Impedanzzielwert für den Eingangsanschluss der Impedanzanpassungsschaltung veränderbar ist. An dem Eingangsanschluss ist der HF-Generator anschließbar. Weicht dieser Impedanzzielwert von der Nennimpedanz ab, so ist der HF-Generator mit dem Eingangsanschluss fehlangepasst. Der HF-Generator wird dabei in einem anderen Arbeitspunkt betrieben als in demjenigen, in welchem er die maximale Leistung abgeben kann. Stattdessen wird ein Arbeitspunkt eingestellt, bei welchem sich die Effizienz erhöht, mit welcher der HF-Generator betrieben werden kann. Durch die erhöhte Effizienz sinkt der Energieverbrauch des HF-Generators signifikant und der Plasmaprozess läuft energiesparsamer ab. Untersuchungen haben ergeben, dass in einem Plasmaprozess selten die maximale Leistung des HF-Generators benötigt wird, die dieser bereitstellen kann. Eine solche maximale Leistung kann der HF-Generator bei Anpassung bereitstellen, also dann, wenn der Impedanzzielwert auf die Nennimpedanz des HF-Generators eingestellt wird. In diesem Betriebszustand benötigt der HF-Generator allerdings auch die meiste Energie.

Die Betriebsfrequenz des HF-Generators ist bevorzugt frei einstellbar. Der HF-Generator ist insbesondere bei Plasmaprozessen dazu ausgelegt, um HF-Signale zu erzeugen und auszugeben, die im Bereich von vorzugsweise 1 MHz bis 200 MHz, bevorzugt im Bereich von 3 MHz bis 100 MHz und weiter bevorzugt im Bereich von 12 MHz bis 50 MHz liegen. Weiter bevorzugt ist der HF-Generator dazu ausgebildet, um HF-Signale mit Frequenzen von 13,56 MHz, 27 MHz und/oder 40 MHz zu erzeugen.

Grundsätzlich ist es denkbar, dass der HF-Generator dazu ausgebildet sein kann, um das HF-Signal zu modulieren.

Unter "Effizienz" wird bevorzugt die in die Last eingekoppelte Leistung (insbesondere Wirkleistung) bezogen auf die vom Generator aufgenommene Leistung (insbesondere Wirkleistung) verstanden.

In einer bevorzugten Ausführungsform umfasst der Betriebskennwert eine oder mehrere der folgenden Eigenschaften des HF-Generators:
a) Effizienz;
b) Temperatur, insbesondere die Begrenzung auf eine maximal zulässige Temperatur, in bestimmten Bauteilen, z.B. Transistoren, Kapazitäten, Induktivitäten, Kopplern, Anpassungsschaltungen;
c) Spannung, insbesondere die Begrenzung auf eine maximal zulässige Spannung, in bestimmten Bauteilen, z.B. Transistoren, Kapazitäten, Induktivitäten, Kopplern, Anpassungsschaltungen;
d) Strom, Spannungen, insbesondere die Begrenzung auf einen maximal zulässigen Strom, in bestimmten Bauteilen, z.B. Transistoren, Kapazitäten, Induktivitäten, Kopplern, Anpassungsschaltungen.

Auch die Eigenschaften des HF-Generators, die sich auf Temperatur, Spannung und Strom beziehen, können Einfluss auf die Effizienz haben. Die Begrenzung auf eine maximal zulässige Temperatur kann mit einem maximal zulässigen Energieverbrauch korrelieren. In vergleichbarer Weise kann auch eine Begrenzung auf eine maximal zulässige Spannung bzw. auf einen maximal zulässigen Strom mit einem maximal zulässigen Energieverbrauch korrelieren.

In einer bevorzugten Ausführungsform handelt es sich bei der Zielleistung, die einstellbar ist, um eine Wirkleistung. Die Zielleistung ist dabei selten auch diejenige Leistung, die in die Last abgegeben wird, weil eine Impedanzanpassungsschaltung Wirkleistungsverluste aufweisen kann, die zudem von der Einstellung der Impedanzanpassungsschaltung abhängen kann. Für die Effizienz des Plasmaprozesses ist dies allerdings weniger ein Hindernis, weil die Wirkleistungsverluste in der Impedanzanpassungsschaltung reproduzierbar sind. So ist sichergestellt, dass ein für eine bestimmte Zielleistung funktionierender Plasmaprozess auch in Zukunft funktioniert.

In einer weiteren bevorzugten Ausführungsform ist die Steuerungsvorrichtung dazu ausgebildet, um die Impedanzanpassungsschaltung derart anzusteuern, dass diese die Impedanz des Eingangsanschlusses der Impedanzanpassungsschaltung auf den Impedanzzielwert einstellt. Dies kann vor Aktivieren des HF-Generators oder im Betrieb des HF-Generators erfolgen. Die Steuerungsvorrichtung ist auch dazu ausgebildet, um die Impedanzzielwerte während des Betriebs des HF-Generators fortlaufend anzupassen, also zu ändern.

In einer weiteren bevorzugten Ausführungsform beträgt die Nennimpedanz 50 Ohm. Dies ist eine standardisierte Größe und die meisten Kabel bzw. Stecker sind hierauf ausgelegt. Die Ausgangsimpedanz des HF-Generators ist üblicherweise auf die Nennimpedanz ausgelegt, damit sich mit den Komponenten keine Reflexionen ergeben.

In einer weiteren bevorzugten Ausführungsform ist die Steuerungsvorrichtung dazu ausgebildet, um denjenigen Impedanzzielwert zu wählen, für den die Effizienz gegenüber einer Effizienz für die Nennimpedanz verbessert ist. Vorzugsweise wird derjenige Impedanzzielwert gewählt, für den die Effizienz gegenüber der Effizienz für die Nennimpedanz um mindestens 5%, 10%, 15%, 20%, 25%, 30%, 35%, 40% oder um mindestens 45% verbessert ist.

In einer weiteren bevorzugten Ausführungsform umfassen die Modellparameter des HF-Generators für verschiedene vorgebbare Zielleistungen dazu korrespondierende Impedanzzielwerte. Für die jeweiligen Impedanzzielwerte erreicht die Effizienz ihr Maximum oder ist höchstens um 10% von ihrem Maximum entfernt. Die Modellparameter können dabei beispielsweise in einer Look-Up-Tabelle gespeichert werden. Entsprechende Modellparameter gibt es für die jeweils unterschiedlichen Betriebsfrequenzen. Vorzugsweise gibt es für jede Betriebsfrequenz eine eigene Look-Up-Tabelle bzw. eine Look-Up-Tabelle ist für eine oder mehrere Betriebsfrequenzen bzw. einen Frequenzbereich gültig. Es ist auch denkbar, dass eine Look-Up-Tabelle mit einem entsprechendem Umrechnungsfaktor (Wert oder Funktion) verrechnet wird, sodass diese Look-Up-Tabelle je nach Umrechnungsfaktor für verschiedene Betriebsfrequenzen verwendet werden kann. Dadurch kann der Speicherplatz reduziert werden. Zu Speicherung der Look-Up-Tabelle umfasst die Steuerungsvorrichtung bevorzugt eine Speichervorrichtung. Weiter bevorzugt sind in der Look-Up-Tabelle zu verschiedenen Zielleistungen dazu korrespondierende Impedanzzielwerte gespeichert, für welche die Effizienz ihr Maximum erreicht oder höchstens um 10 % von ihrem Maximum entfernt ist.

In einer weiteren bevorzugten Ausführungsform liegen die verschiedenen Zielleistungen auf einer Kurve oder einer Kurvenschar. Bei Einsatz einer Kurve wird vorzugsweise das Maximum der Effizienz erreicht. Bei Einsatz einer Kurvenschar können die Zielleistungen vorzugsweise um 10% oder weniger vom Maximum der Effizienz entfernt liegen. Dadurch ist für den Benutzer eine Visualisierung möglich, sodass er beim Einstellen des Plasmaprozesses unterstützt wird, insbesondere die Einstellung nach den zuvor genannten Kriterien für ihn überhaupt erst möglich wird.

In einer weiteren bevorzugten Ausführungsform ist die Steuerungsvorrichtung dazu ausgebildet, um für benachbarte Zielleistungen auf der Kurve oder Kurvenschar diejenigen Impedanzzielwerte zu hinterlegen, deren Aufruf hintereinander eine minimale mechanische Verstellung der Impedanzanpassungsschaltung erfordert. Beispielsweise können die Zielleistungen in einer Auflösung von einem Zehntel (0,1) hinterlegt sein. Benachbarte Zielleistungen wären dann in diesem Fall beispielsweise 49 dBm und 49,1 dBm. Es könnten dann diejenigen Impedanzzielwerte ausgewählt werden, für welche die entsprechend erhöhte Effizienz erreicht wird, wobei die mechanische Verstellung (der mechanische Verfahrweg) von Kondensatoren und/oder Induktivitäten minimal gehalten wird. Dadurch kann der Motor und/oder das Getriebe der Impedanzanpassungsschaltung geschont werden.

In einer weiteren bevorzugten Ausführungsform ist die Steuerungsvorrichtung dazu ausgebildet, um zusätzlich die Modellparameter einer Kabelimpedanz einer Kabelverbindung zwischen dem HF-Generator und der Impedanzanpassungsschaltung zu berücksichtigen. Die Kabelimpedanz ist ebenfalls frequenzabhängig, sodass für verschiedene Betriebsfrequenzen unterschiedliche Kabelimpedanzen berücksichtigt werden. Dadurch kann die Effizienz des HF-Generators genauer eingestellt werden.

In einer weiteren bevorzugten Ausführungsform ist die Steuerungsvorrichtung dazu ausgebildet, um die Kabelimpedanz aus einer Speichervorrichtung zu laden. In diesem Fall könnte die Kabelimpedanz beispielsweise in derselben Speichervorrichtung gespeichert sein, in welcher auch die Look-Up-Tabelle gespeichert ist.

In einer weiteren bevorzugten Ausführungsform ist die Steuerungsvorrichtung dazu ausgebildet, um die Kabelimpedanz mittels einer ersten und zweiten Messeinheit zu berechnen. Die erste Messeinheit ist zwischen dem HF-Generator und der Kabelverbindung anordenbar. Die zweite Messeinheit ist zwischen der Kabelverbindung und der Impedanzanpassungsschaltung oder zwischen der Impedanzanpassungsschaltung und der Last anordenbar. Die erste Messeinheit ist daher insbesondere im Bereich des Ausgangsanschlusses des HF-Generators anordenbar und die zweite Messeinheit ist daher insbesondere im Bereich des Eingangsanschlusses oder des Ausgangsanschlusses der Impedanzanpassungsschaltung anordenbar. Die Steuerungsvorrichtung ist daher dazu ausgebildet, um vor Aktivieren des HF-Generators die aktuelle Kabelimpedanz der Kabelverbindung zu ermitteln und/oder eine Änderung der Kabelimpedanz der Kabelverbindung im Betrieb zu detektieren. Bei Anschluss einer anderen Kabelverbindung werden somit automatisch die richtigen Werte für die Kabelimpedanz herangezogen. Für den Fall, dass die zweite Messeinheit nach der Impedanzanpassungsschaltung und vor der Last angeordnet ist, müssen noch die Modelparameter, insbesondere die Z-Parameter der Impedanzanpassungsschaltung berücksichtigt werden. Diese sind allerdings für den aktuellen Zustand der Impedanzanpassungsschaltung jeweils bekannt. Die Kabelimpedanz kann auch als Modellparameter für die Kabelverbindung bezeichnet werden. So kann gesagt werden, dass die Steuerungsvorrichtung ebenfalls dazu ausgebildet ist, um die Modellparameter für die Kabelverbindung zu berücksichtigen.

In einer weiteren bevorzugten Ausführungsform umfasst die Steuerungsvorrichtung für unterschiedliche Betriebsfrequenzen des HF-Generators unterschiedliche Modellparameter.

In einer weiteren bevorzugten Ausführungsform ist der Eingangsanschluss der Impedanzanpassungsschaltung am Gehäuse der Impedanzanpassungsschaltung angeordnet. Grundsätzlich wäre es allerdings auch denkbar, dass der HF-Generator über eine Kabelverbindung mit der Impedanzanpassungsschaltung verbindbar ist, wobei ein erstes Ende der Kabelverbindung an den HF-Generator anschließbar ist und wobei ein zweites Ende der Kabelverbindung an die Impedanzanpassungsschaltung anschließbar ist, wobei der Eingangsanschluss am ersten Ende der Kabelverbindung und damit am HF-Generator angeordnet ist. In diesem Fall ist der Eingangsanschluss nicht direkt am Gehäuse der Impedanzanpassungsschaltung angeordnet. Dadurch wird verdeutlicht, dass die Kabelverbindung mitberücksichtigt werden kann und die Steuerungsvorrichtung eingerichtet ist, einen Impedanzzielwert direkt am Ausgang des HF-Generators einzustellen, der auf den HF-Generator wirkt.

In einer weiteren bevorzugten Ausführungsform ist die Steuerungsvorrichtung dazu ausgebildet, um bei einem gepulsten Betrieb des HF-Generators, in welchem Pulse mit unterschiedlicher Amplitude und vorzugsweise auch mit Pulspausen erzeugt werden, für die unterschiedlichen Pulse unterschiedliche Impedanzzielwerte für den Eingangsanschluss der Impedanzanpassungsschaltung zu ermitteln. Dadurch kann die Effizienz maximiert werden.

In einer weiteren bevorzugten Ausführungsform ist die Steuerungsvorrichtung dazu ausgebildet, um Impedanzzielwerte für den Eingangsanschluss der Impedanzanpassungsschaltung zu ermitteln, wobei die Impedanzzielwerte derart gewählt sind, dass der HF-Generator eine entsprechende Zielleistung für die gesamte Hüllkurve eines erzeugten Signals bereitstellen kann. Dies bedeutet, dass die Leistung des HF-Generators ausreicht, um die Amplitude des erzeugten Signals vollständig nachzufahren. So soll der HF-Generator auch für die Spitzen des erzeugten Signals ausreichend Leistung bereitstellen können. In diesem Fall ist der Impedanzzielwert derart zu wählen, dass der HF-Generator immer noch die notwendige maximale Leistung erzeugen kann.

Das erfindungsgemäße Plasmaerzeugungssystem umfasst eine entsprechende Steuerungsvorrichtung wie diese eingangs beschrieben wurde. Weiterhin umfasst das Plasmaerzeugungssystem einen HF-Generator und eine Impedanzanpassungsschaltung. Der Ausgangsanschluss des HF-Generators ist dabei mit dem Eingangsanschluss der Impedanzanpassungsschaltung verbunden. Vorzugsweise ist ein Ausgangsanschluss der Impedanzanpassungsschaltung mit einer Last, insbesondere zumindest einer Elektrode in einer Plasmakammer verbunden.

In einer weiteren Ausführungsform ist die Impedanzanpassungsschaltung im HF-Generator integriert. Dies hat den Vorteil, dass die Impedanzanpassungsschaltung nicht noch die Kabelimpedanz, die vorzugsweise bei 50 Ohm liegt, berücksichtigen muss. So ist beispielsweise die Transformation der Transistorimpedanz, die bei 5 Ohm liegt, hin zur Plasmaimpedanz, die vorzugsweise bei 2 Ohm liegt, leichter zu bewerkstelligen, weil die Bauteile der Impedanzanpassungsschaltung (zum Beispiel Kondensatoren, Induktivitäten) weniger stark verstellt werden müssen.

In einer weiteren bevorzugten Ausführungsform ist die Steuerungsvorrichtung dazu ausgebildet, um bei Ermittlung des Impedanzzielwerts am Eingangsanschluss der Impedanzanpassungsschaltung die Kabelimpedanz der Kabelverbindung zwischen dem HF-Generator und der Impedanzanpassungsschaltung zu berücksichtigen. Bevorzugt wird die Kabelimpedanz fortlaufend (z.B. mehrere Male pro Sekunde) gemessen, sodass bei einer sich ändernden Kabelimpedanz die Impedanzanpassungsschaltung im Betrieb verstellt wird, sodass der gewünschte Impedanzzielwert weiterhin erreicht wird.

In einer weiteren bevorzugten Ausführungsform umfasst das Plasmaerzeugungssystem eine erste und eine zweite Messeinheit. Die Steuerungsvorrichtung ist dazu ausgebildet, um die Kabelimpedanz der Kabelverbindung zwischen dem HF-Generator und der Impedanzanpassungsschaltung mittels der ersten und der zweiten Messeinheit zu berechnen. Die erste Messeinheit ist zwischen dem HF-Generator und der Kabelverbindung angeordnet. Die erste Messeinheit ist näher am HF-Generator angeordnet und die zweite Messeinheit ist näher an der Impedanzanpassungsschaltung angeordnet. Die zweite Messeinheit ist zwischen der Kabelverbindung und der Impedanzanpassungsschaltung oder zwischen der Impedanzanpassungsschaltung und der Last angeordnet.

In einer weiteren bevorzugten Ausführungsform ist die erste Messeinheit ein Richtkoppler. Ergänzend oder alternativ ist die zweite Messeinheit ein Richtkoppler. Ergänzend oder alternativ umfasst die erste Messeinheit einen Stromsensor und einen Spannungssensor. Ergänzend oder alternativ umfasst die zweite Messeinheit einen Stromsensor und einen Spannungssensor. Mittels dieser Sensoren kann die Kabelimpedanz der Kabelverbindung berechnet werden.

In einer weiteren bevorzugten Ausführungsform umfasst der Spannungssensor der ersten Messeinheit ein kapazitiver Spannungsteiler, wobei eine erste Kapazität durch einen elektrisch leitfähigen Ring oder Zylinder gebildet ist, durch den die Kabelverbindung zwischen dem HF-Generator und der Impedanzanpassungsschaltung geführt ist. Der Stromsensor der ersten Messeinheit umfasst eine Spule, die um den leitfähigen Ring oder Zylinder herum angeordnet ist. Dadurch kann ein kompakter Aufbau realisiert werden. Ergänzend oder alternativ umfasst der Spannungssensor der zweiten Messeinheit ein kapazitiver Spannungsteiler, wobei eine erste Kapazität durch einen elektrisch leitfähigen Ring oder Zylinder gebildet ist. Durch den Zylinder ist entweder die Kabelverbindung zwischen dem HF-Generator und der Impedanzanpassungsschaltung geführt oder die Kabelverbindung zwischen der Impedanzanpassungsschaltung und der Last. Der Stromsensor der zweiten Messeinheit umfasst eine Spule, die um den leitfähigen Ring oder Zylinder herum angeordnet ist. Dadurch kann ein besonders kompakter Aufbau realisiert werden.

In einer weiteren bevorzugten Ausführungsform ist die Steuerungsvorrichtung dazu ausgebildet, um die Leistung des HF-Generators zu verändern, wobei dies durch eine Änderung einer Eingangsleistung eines Verstärkers des HF-Generators und/oder durch Änderung einer Versorgungsspannung eines Verstärkers des HF-Generators erfolgt. Dadurch kann der HF-Generator noch genauer auf eine weiter verbesserte Effizienz getrimmt werden.

In einer weiteren bevorzugten Ausführungsform umfasst die erste Kabelverbindung zumindest zwei parallel geschaltete Kabel, um dadurch die Impedanz der Kabelverbindung zu reduzieren. In diesem Fall werden die Enden der beiden Innenleiter jeweils miteinander elektrisch verbunden, insbesondere verlötet. Aus zwei 50 Ohm Kabeln würde so ein 25 Ohm Kabel geschaffen werden. In diesem Fall wäre die Nennimpedanz des Systems 25 Ohm. Durch diese Maßnahme ist ein Übergang von einer Transistorimpedanz des HF-Generators von ca. 5 Ohm auf die Kabelimpedanz von 25 Ohm hin zur Plasmaimpedanz von ca. 2 Ohm geringer als von 5 Ohm auf die Kabelimpedanz von den standardisierten 50 Ohm hin zur Plasmaimpedanz von ca. 2 Ohm. Das vermindert weiter die Verluste.

In einer weiteren bevorzugten Ausführungsform umfasst die Impedanzanpassungsschaltung eine oder mehrere Kapazitäten, wobei der Wert zumindest einer Kapazität im Betrieb veränderbar ist. Die Veränderung kann durch Ansteuerung eines Drehkondensators, insbesondere Vakuum-Drehkondensators, mittels eines Motors, insbesondere Schrittmotors, erfolgen. Vorzugsweise ist noch ein Getriebe vorgesehen. Anstelle eines Motors kann auch ein Schalter, insbesondere in Form eines Halbleiterschalters (Solid State Switch) verwendet werden, um Kapazitäten zu- und/oder wegzuschalten. Insbesondere können mehrere solcher geschalteten Kapazitäten vorgesehen sein, um eine Mehrzahl unterschiedlicher Kapazitätswerte einstellen zu können. In diesem Fall kann der Impedanzzielwert besonders schnell, insbesondere schneller als mit einer motorbetriebenen Kondensatorverstellung, bevorzugt in weniger als 100 ms, 50 ms, 10 ms oder in weniger als 1 ms, eingestellt werden. Dies ist insbesondere bei Einsatz eines gepulsten Signals sinnvoll, um schnell auf unterschiedliche Pulshöhen reagieren zu können.

Das erfindungsgemäße Verfahren dient zur Ansteuerung einer Impedanzanpassungsschaltung für ein Plasmaerzeugungssystem mit einem Eingangsanschluss, der mit einem Ausgangsanschluss eines HF-Generators verbunden ist, und einem Ausgangsanschluss, der mit dem Eingang einer Last verbunden ist. Das Verfahren ist geeignet zum Einstellen der Eingangs-Impedanz am Eingangsanschluss bei veränderlicher Ausgangs-Impedanz am Ausgangsanschluss mit den folgenden Verfahrensschritten:
- Ermitteln eines Impedanzzielwerts für den Eingangsanschluss anhand von:
   a) einer vorgebbaren Betriebsfrequenz des HF-Generators;
   b) einer vorgegebenen Zielleistung des HF-Generators;
      und
   c) Modelparametern des HF-Generators;
wobei der Impedanzzielwert einen von der Nennimpedanz abweichenden Wert aufweist, um eine Erhöhung eines Betriebskennwerts des HF-Generators, insbesondere der Effizienz, für die vorgebbare Betriebsfrequenz und die vorgebbare Zielleistung zu erreichen.

Verschiedene Ausführungsbeispiele der Erfindung werden nachfolgend unter Bezugnahme auf die Zeichnungen beispielhaft beschrieben. Gleiche Gegenstände weisen dieselben Bezugszeichen auf. Die entsprechenden Figuren der Zeichnungen zeigen im Einzelnen:
- Figur 1:: ein Ausführungsbeispiel eines Plasmaerzeugungssystems, welches einen HF-Generator, eine Impedanzanpassungsschaltung, eine Steuerungsvorrichtung und eine Plasmakammer umfasst;
- Figuren 2A, 2B:: verschiedene Ausführungsbeispiele der Impedanzanpassungsschaltung;
- Figur 3:: ein Ausführungsbeispiel einer ersten und/oder zweiten Messeinheit, um berührungslos eine Spannung und einen Strom zu messen;
- Figur 4:: ein Smithdiagramm, welches verdeutlicht wie der HF-Generator in Abhängigkeit des Impedanzzielwerts von maximaler Leistung hin zu maximaler Effizienz übergeht;
- Figur 5:: ein Diagramm, welches einen Verlauf der Effizienz für bestimmte Zielleistungen im Zusammenhang mit den notwendigen Impedanz-Zielwerten darstellt; und
- Figur 6:: ein Flussdiagramm, welches ein Verfahren zur Ansteuerung der Impedanzanpassungsschaltung beschreibt.

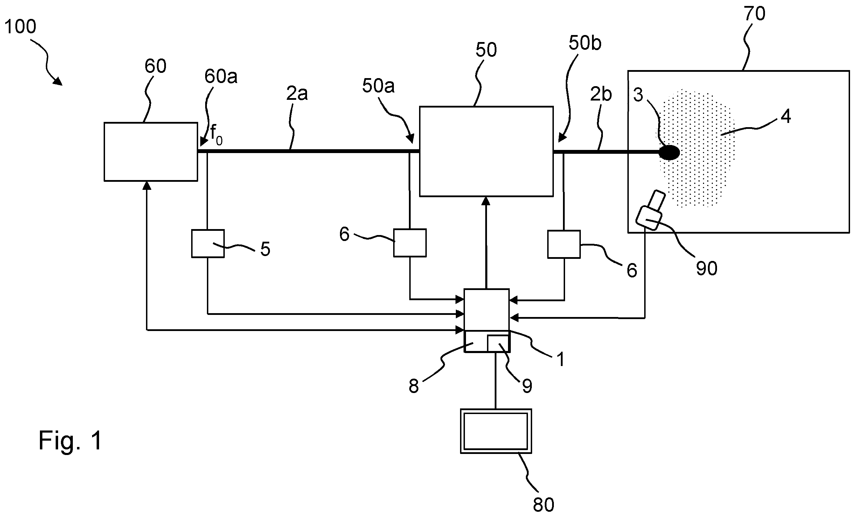

Die Figur 1 zeigt ein Plasmaerzeugungssystem 100, welches u.a. zur Oberflächenbehandlung von Werkstücken eingesetzt wird.

Das Plasmaerzeugungssystem 100 umfasst eine Steuerungsvorrichtung 1, eine Impedanzanpassungsschaltung 50, einen HF-Generator 60 und eine Plasmakammer 70 als Last. Der HF-Generator 60 ist mit der Impedanzanpassungsschaltung 50 elektrisch verbunden. Dies erfolgt über eine Kabelverbindung 2a, bei welcher es sich bevorzugt um eine erste Kabelverbindung 2a, insbesondere um zumindest ein erstes Koaxialkabel 2a handelt. Die erste Kabelverbindung 2a ist mit einem Ausgangsanschluss 60a des HF-Generators 60 und mit einem Eingangsanschluss 50a der Impedanzanpassungsschaltung 50 verbunden. Die Impedanzanpassungsschaltung 50 ist weiterhin mit der Plasmakammer 70 elektrisch verbunden. Dies erfolgt bevorzugt über eine weitere, insbesondere zweite Kabelverbindung 2b, bei welcher es sich bevorzugt um ein zweites Koaxialkabel 2b handelt. Häufig ist die Impedanzanpassungsschaltung 50 nah an der Plasmakammer 70 angeordnet, insbesondere mit einem Abstand von 10 cm oder weniger als 10 cm, bevorzugt direkt an dieser angeordnet, so dass die zweite Kabelverbindung 2b auch entsprechend kurz ausgestaltet ist und nur wenige mechanische Teile, wie z.B. Stecker und/oder Leitungsverbinder aufweist. Die zweite Kabelverbindung 2b ist mit einem Ausgangsanschluss 50b der Impedanzanpassungsschaltung 50 und mit einem Eingang der Plasmakammer 70 verbunden. Bevorzugt ist die zweite Kabelverbindung 2b mit einer Elektrode innerhalb der Plasmakammer 70 verbunden.

Die erste Kabelverbindung 2a ist länger als die zweite Kabelverbindung 2b. Vorzugsweise ist die erste Kabelverbindung 2a um den Faktor 2, 3, 4, 5, 6, 7 oder mindestens um den Faktor 8 länger als die zweite Kabelverbindung 2b.

Die erste Kabelverbindung 2a kann auch zumindest zwei parallel geschaltete Kabel umfassen, um die Gesamt-Impedanz der Kabelverbindung zu reduzieren. In diesem Fall werden die Enden der beiden Innenleiter jeweils miteinander elektrisch verbunden, insbesondere verlötet. Aus zwei 50 Ohm Kabeln würde so ein 25 Ohm Kabel geschaffen werden. Dadurch ist ein Übergang von einer Transistorimpedanz des HF-Generators 60 von ca. 5 Ohm auf die Kabelimpedanz von 25 Ohm hin zur Plasmaimpedanz von ca. 2 Ohm geringer. In diesem Fall wäre die Nennimpedanz 25 Ohm.

Das Plasmaerzeugungssystem 100 umfasst bevorzugt eine Ein- und Ausgabevorrichtung 80, bei welcher es sich vorzugsweise um einen, insbesondere berührungsempfindlich steuerbaren, Bildschirm handelt. Auch eine Tastatur und/oder eine Maus und ein Monitor können als Ein- und Ausgabevorrichtung 80 angesehen werden.

Die Plasmakammer 70 kann als Verbraucher (Last) angesehen werden. Je nach Anwendungsfall können in der Plasmakammer 70 beispielsweise eine oder mehrere Elektroden 3 vorgesehen sein, von denen zumindest eine mit der zweiten Kabelverbindung 2b verbunden ist. Ein Plasma 4 ist in Figur 1 innerhalb der Plasmakammer 70 gepunktet dargestellt.

Vorzugsweise umfasst das Plasmaerzeugungssystem 100 noch eine optische Vorrichtung 90. Die optische Vorrichtung 90 ist weiter vorzugsweise in der Plasmakammer 70 angeordnet und dazu ausgebildet, um das Plasma 4 visuell und damit den Plasmazustand zu erfassen. Bei der optischen Vorrichtung 90 kann es sich beispielsweise um einen optischen Leiter wie beispielsweise eine Glasfaser handeln. Kameras können zwar eingesetzt werden, allerdings wird häufig aus Kostengründen auf diese verzichtet. Außerdem können Linsen und andere Schutzgläser durch das Plasma 4 schnell trübe werden.

Die Steuerungsvorrichtung 1 ist vorzugsweise ein Prozessor (zum Beispiel Mikrocontroller) und/oder programmierbarer Logikbaustein, z.B. ein FPGA (Field Programmable Gate Array).

Die Steuerungsvorrichtung 1 dient zur Ansteuerung der Impedanzanpassungsschaltung 50. Die Steuerungsvorrichtung 1 ist dazu ausgebildet, um anhand einer vorgebbaren Betriebsfrequenz des HF-Generators 60, einer vorgegebenen Zielleistung des HF-Generators 60 und anhand von Modellparametern des HF-Generators 60 einen Impedanzzielwert für den Eingangsanschluss 50a zu ermitteln, wobei der Impedanzzielwert einen von der Nennimpedanz (meistens 50 Ohm) abweichenden Wert aufweist, um dadurch eine Erhöhung eines Betriebskennwerts des HF-Generators 60, insbesondere um dadurch eine Erhöhung der Effizienz, für die vorgebbare Betriebsfrequenz und die vorgebbare Zielleistung zu erreichen.

Die Modellparameter des HF-Generators 60 umfassen für verschiedene vorgebbare Zielleistungen dazu korrespondierende Impedanzzielwerte für welche die Effizienz ihr Maximum erreicht oder höchstens um 10 % von ihrem Maximum entfernt ist. Diese Zielleistungen können beispielsweise durch einen Benutzer über die Ein- und Ausgabevorrichtung 80 eingegeben werden. Sie können auch in der Steuerungsvorrichtung 1 für einen bestimmten Plasmaprozess hinterlegt sein. Wählt ein Benutzer einen bestimmten Plasmaprozess aus, so wird eine für diesen Plasmaprozess hinterlegte Zielleistung abgerufen und ein entsprechender Impedanzzielwert geladen.

In der Speichervorrichtung 8 ist bevorzugt eine Look-Up-Tabelle 9 gespeichert, in welcher zu verschiedenen Zielleistungen dazu korrespondierende Impedanzzielwerte hinterlegt sind, für welche die Effizienz ihr Maximum erreicht oder höchstens um 10% von ihrem Maximum entfernt ist.

In Figur 1 ist der Eingangsanschluss 50a der Impedanzanpassungsschaltung 50 direkt am Gehäuse der Impedanzanpassungsschaltung 50 eingezeichnet. Grundsätzlich könnte dieser auch an demjenigen Ende der ersten Kabelverbindung 2a anliegen, an dem die erste Kabelverbindung 2a mit dem HF-Generator 60 verbunden ist. Dadurch wird die Kabelimpedanz der ersten Kabelverbindung 2a noch mitberücksichtigt. In diesem Fall sieht der HF-Generator 60 direkt den Impedanzzielwert, welcher nicht noch durch die erste Kabelverbindung 2a verfälscht wird.

Wie bereits erläutert, ist es bevorzugt, wenn die Steuerungsvorrichtung 1 dazu ausgebildet ist, um zusätzlich die Modellparameter einer Kabelimpedanz der ersten Kabelverbindung 2a zwischen dem HF-Generator 60 und der Impedanzanpassungsschaltung 50 zu berücksichtigen. Die Modellparameter für die Kabelimpedanz können in einer Speichereinrichtung 8 hinterlegt sein. Diese Modellparameter sind frequenzabhängig und je nach Betriebsfrequenz des HF-Generators 60 werden unterschiedliche Kabelimpedanzen geladen.

Die Steuerungsvorrichtung 1 könnte auch dazu ausgebildet sein, die Kabelimpedanz der ersten Kabelverbindung mittels einer ersten und zweiten Messeinheit 5, 6 zu berechnen, wobei die erste Messeinheit 5 zwischen HF-Generator 60 und der ersten Kabelverbindung 2a angeordnet ist und wobei die zweite Messeinheit 6 zwischen der ersten Kabelverbindung 2a und Impedanzanpassungsschaltung 50 oder zwischen der Impedanzanpassungsschaltung 50 und der Last 70 angeordnet ist. In Figur 1 ist eine zweite Messeinheit 6 dargestellt. Für den Fall, dass die zweite Messeinheit 6 zwischen der Impedanzanpassungsschaltung 50 und der Last 70 angeordnet ist, ist die Steuerungsvorrichtung 1 dazu ausgebildet, um zusätzlich die Modellparameter der Impedanzanpassungsschaltung 50 zu berücksichtigen.

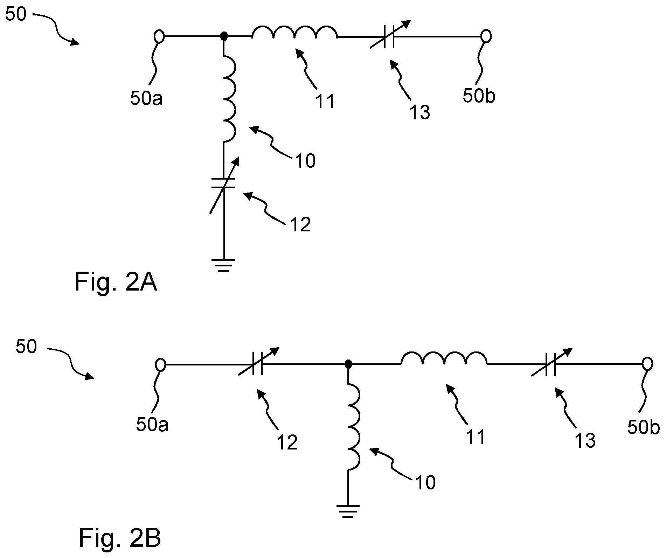

Die Figuren 2A, 2B zeigen verschiedene Ausführungsbeispiele der Impedanzanpassungsschaltung 50. In Figur 2A ist die Impedanzanpassungsschaltung 50 L-förmig. In Figur 2B ist Impedanzanpassungsschaltung 50 T-förmig.

Der Eingangsanschluss 50a der Impedanzanpassungsschaltung 50 ist in Figur 2A mit einer ersten Spule 10 (erste Induktivität) und mit einer zweiten Spule 11 (zweite Induktivität) verbunden. Die erste und die zweite Spule 10, 11 liegen mit ihrem ersten Anschluss an einem gemeinsamen Knoten und damit am Eingangsanschluss 50a der Impedanzanpassungsschaltung 50 an. Die erste Spule 10 ist über einen ersten Kondensator 12 (erste Kapazität) mit einer Bezugsmasse verbunden. Die zweite Spule 11 ist über einen zweiten Kondensator 13 (zweite Kapazität) mit dem Ausgangsanschluss 50b verbunden. Bei dem ersten und zweiten Kondensator 12, 13 handelt es sich um verstellbare Bauelemente, insbesondere in Form von Drehkondensatoren, deren Kapazität über Schrittmotoren verändert werden kann. Alternativ können Solid State Switches eingesetzt werden, um Kapazitäten schneller zu- und wegschalten zu können. Insbesondere kann der Plattenabstand der ersten und zweiten Kondensatoren 12, 13 geändert werden. Die Plasmazünderkennungsvorrichtung 1 ist dazu ausgebildet, um die jeweiligen Schrittmotoren entsprechend anzusteuern. Grundsätzlich kann die Verarbeitungseinheit 7 die Ansteuerung durchführen. Die Kapazitäten der ersten und zweiten Kondensatoren 12, 13 können unabhängig voneinander verstellt werden. Vorzugsweise ist Impedanzanpassungsschaltung 50 frei von weiteren Bauteilen. Selbstverständlich kann die Position der ersten Spule 10 und des ersten Kondensators 12 auch getauscht sein. In diesem Fall ist der erste Kondensator 12 am Eingangsanschluss 50a der Impedanzanpassungsschaltung 50 und die erste Spule 10 an der Bezugsmasse angeordnet. Ergänzend oder alternativ kann die Position der zweiten Spule 11 und des zweiten Kondensators 13 auch getauscht sein. In diesem Fall ist der zweite Kondensator 13 am Eingangsanschluss 50a der Impedanzanpassungsschaltung 50 und die zweite Spule 11 an der Bezugsmasse angeordnet.

Der Eingangsanschluss 50a der Impedanzanpassungsschaltung 50 ist in Figur 2B mit dem ersten Kondensator 12 (erste Kapazität) verbunden. Der erste Kondensator 12 ist sowohl mit der ersten Spule 10 (erste Induktivität) als auch mit der zweiten Spule 11 (zweite Induktivität) verbunden. Dies erfolgt über einen gemeinsamen Knoten, an den sowohl der erste Kondensator 12 als auch die erste und die zweite Spule 10, 11 angeschlossen sind. Die erste Spule 10 ist weiterhin mit der Bezugsmasse verbunden. Die zweite Spule 11 ist mit dem zweiten Kondensator 13 (zweite Kapazität) verbunden (Reihenschaltung). Der zweite Kondensator 13 ist mit dem Ausgangsanschluss 50b der Impedanzanpassungsschaltung 50 verbunden. Die Position der zweiten Spule 11 und des zweiten Kondensators 13 könnte auch vertauscht sein. In diesem Fall wäre der zweite Kondensator 13 an den gemeinsamen Knoten und die zweite Spule 11 an den Ausgangsanschluss 50b der Impedanzanpassungsschaltung 50 angeschlossen. Vorzugsweise ist Impedanzanpassungsschaltung 50 frei von weiteren Bauteilen.

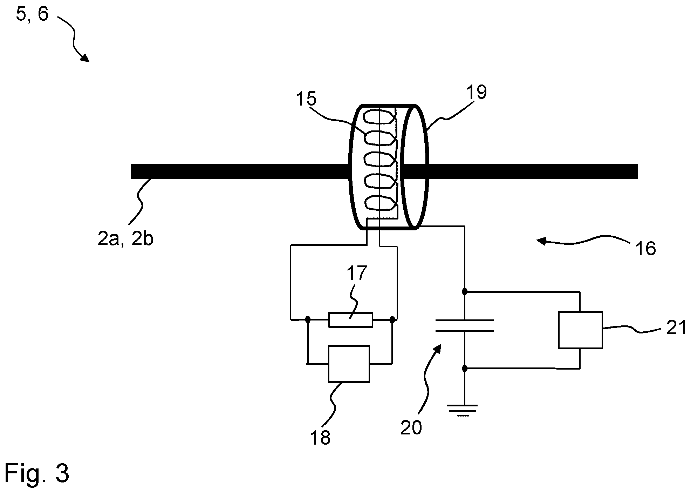

Figur 3 zeigt ein Ausführungsbeispiel eines möglichen Aufbaus der ersten und/oder zweiten Messeinheit 5, 6. In diesem Ausführungsbeispiel sind die erste und/oder zweite Messeinheit 5, 6 dazu ausgebildet, um berührungslos eine Spannung und berührungslos einen Strom zu messen.

Hierfür umfasst die erste bzw. zweite Messeinheit 5, 6 einen Stromsensor 15 und einen Spannungssensor 16.

Bevorzugt wird allerdings noch die Phasenbeziehung zwischen Strom und Spannung gemessen, damit die Impedanz berechnet werden kann.

Der Stromsensor 15 der ersten und/oder zweiten Messeinheit 5, 6 umfasst eine Spule, insbesondere in Form einer Rogowskispule.

Beide Enden der Spule sind vorzugsweise über einen Shuntwiderstand 17 miteinander verbunden. Die Spannung, die über den Shuntwiderstand 17 abfällt, kann mittels eines ersten A/D-Wandlers (Analog-Digital-Wandlers) 18 digitalisiert werden.

Der Spannungssensor 16 der ersten und/oder zweiten Messeinheit 5, 6 ist vorzugsweise als kapazitiver Spannungsteiler aufgebaut. Eine erste Kapazität 19 ist durch einen elektrisch leitfähigen Ring 19 gebildet. Es könnte auch ein elektrisch leitfähiger Zylinder verwendet werden. Durch diesen elektrisch leitfähigen Ring 19 ist die entsprechende erste bzw. zweite Kabelverbindung 2a, 2b geführt. Eine zweite Kapazität 20 des als Spannungsteiler aufgebauten Spannungssensors 16 ist mit der Bezugsmasse verbunden. Parallel zur zweiten Kapazität 20 ist ein zweiter A/D-Wandler 21 angeschlossen, der dazu ausgebildet ist, um die Spannung, die über der zweiten Kapazität 20 abfällt, zu erfassen und zu digitalisieren.

Grundsätzlich können die erste Messeinheit 5 und die zweite Messeinheit 6 auch auf einer (gemeinsamen) Leiterplatte angeordnet, bzw. aufgebaut sein. Die erste Kapazität 19 kann durch eine Beschichtung auf einer ersten und einer gegenüberliegenden zweiten Seite der Leiterplatte gebildet sein. Die Beschichtungen auf der ersten und der zweiten Seite sind in diesem Fall durch Durchkontaktierungen miteinander elektrisch verbunden. Die erste bzw. zweite Kabelverbindung 2a, 2b ist durch eine Öffnung in der Leiterplatte hindurchgeführt. Die zweite Kapazität 20 kann durch ein diskretes Bauelement gebildet sein.

Der Stromsensor 15 in Form der Spule, insbesondere in Form der Rogowskispule, ist weiter von der ersten bzw. zweiten Kabelverbindung 2a, 2b beabstandet als die erste Kapazität 19. Die Spule kann ebenfalls auf derselben Leiterplatte durch entsprechende Beschichtungen nebst Durchkontaktierungen gebildet sein. Die Spule zur Strommessung und die erste Kapazität zur Spannungsmessung verlaufen bevorzugt durch eine gemeinsame Ebene.

Der Shuntwiderstand 17 kann ebenfalls auf dieser Leiterplatte angeordnet sein. Nichts anderes gilt auch für den ersten und/oder zweiten A/D-Wandler 18, 21.

Für den Fall, dass die erste und die zweite Messeinheit 5, 6 an der ersten Kabelverbindung 2a angeordnet sind, sind diese voneinander beabstandet angeordnet, und zwar so weit, dass eine gegenseitige störende Beeinflussung soweit reduziert ist, dass sie in Anbetracht der gewünschten Messgenauigkeit nur eine untergeordnete Rolle spielt. Die erste Messeinheit 5 ist im Bereich des HF-Generators 60 angeordnet und die zweite Messeinheit 6 ist im Bereich der Impedanzanpassungsschaltung 50 angeordnet.

Die zweite Messeinheit 6 könnte auch am Ausgangsanschluss 50b der Impedanzanpassungsschaltung 50 angeordnet sein, wobei die erste Messeinheit 5 weiterhin im Bereich des HF-Generators 60 angeordnet ist, um so eine Kabelimpedanz der ersten Kabelverbindung 2a erfassen zu können.

Die erste und/oder zweite Messeinheit 5, 6 könnten auch als Richtkoppler ausgebildet sein.

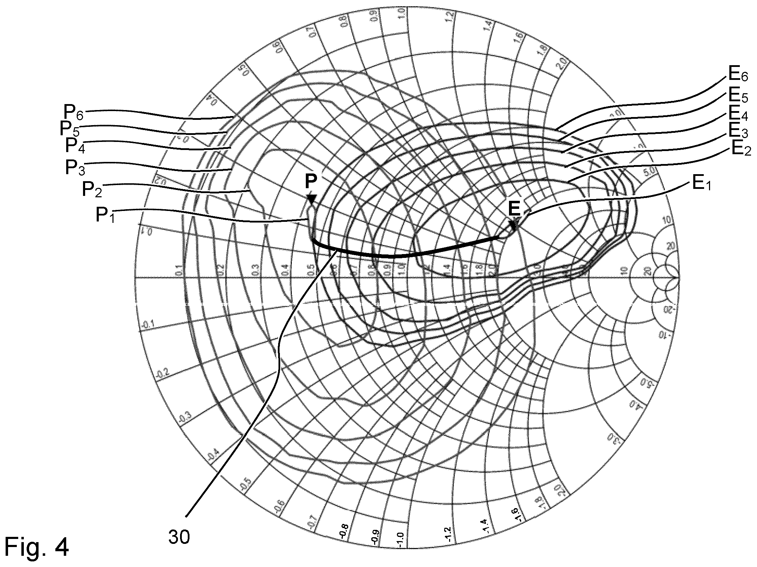

Figur 4 zeigt ein Smithdiagramm, welches verdeutlicht wie der HF-Generator 60 in Abhängigkeit des Impedanzzielwerts von maximaler Leistung hin zu maximaler Effizienz übergeht.

In dem Smithdiagramm aus Figur 4 sind beispielhaft sechs Impedanzverläufe P₁, P₂, P₃, P₄, P₅, P₆ dargestellt. Jeder Impedanzzielwert, welcher auf einem Impedanzverlauf liegt, bedeutet, dass der HF-Generator 60 die gleiche Ausgangsleistung aufweist. Dies bedeutet, dass mit verschiedenen Impedanzzielwerten, die auf demselben Impedanzverlauf liegen, dieselbe Ausgangsleistung des HF-Generators 60 erreicht werden kann. Unterschiedliche Impedanzverläufe resultieren in unterschiedenen Ausgangsleistungen des HF-Generators 60. Der HF-Generator 60 erzeugt eine andere Ausgangsleistung, wenn er einen Impedanzzielwert sieht, der auf dem Impedanzverlauf P₁ liegt verglichen zu einem Impedanzzielwert, der auf dem Impedanzverlauf P₂ liegt.

In Figur 4 sind lediglich beispielhaft sechs Impedanzverläufe P₁, P₂, P₃, P₄, P₅, P₆ dargestellt. Es können auch mehr als sechs sein.

In dem Smithdiagramm aus Figur 4 sind beispielhaft sechs weitere Impedanzverläufe E₁, E₂, E₃, E₄, E₅, E₆ dargestellt. Jeder Impedanzzielwert, welcher auf einem dieser weiteren Impedanzverläufe liegt, bedeutet, dass der HF-Generator 60 die gleiche Effizienz aufweist. Dies bedeutet, dass mit verschiedenen Impedanzzielwerten dieselbe Effizienz für den HF-Generator 60 erreicht werden kann. Unterschiedliche Impedanzverläufe resultieren in unterschiedenen Effizienzen des HF-Generators 60. Der HF-Generator 60 wird mit einer anderen Effizienz betrieben, wenn er einen Impedanzzielwert sieht, der auf dem Impedanzverlauf E₁ liegt verglichen zu einem Impedanzzielwert, der auf dem Impedanzverlauf E₂ liegt.

Nachfolgend werden beispielhaft einige Werte wiedergegeben, um die Darstellung zu verdeutlichen.

| Leistung | Effizienz |
|---|---|
| | |
| P₁ = 47, 7 dBm | E₁ = 91, 5 % |
| P₂ = 47,0 dBm | E₂ = 88, 0 % |
| P₃ = 46,0 dBm | E₃ = 84, 0 % |
| P₄ = 45,0 dBm | E₄ = 80,0 % |
| P₅ = 44,0 dBm | E₅ = 76, 0 % |
| P₆ = 43,0 dBm | E₆ = 72,0 % |

Zu erkennen ist, dass für die maximal mögliche Leistung, die für Impedanzzielwerte erreichbar ist, die auf dem Impedanzverlauf P₁ liegen, eine Effizienz von nur E₆ = 72 % möglich ist. Dagegen ist für eine geringere Leistung P2 = 47,0 dBm eine Effizienz von E3 = 84,0 % möglich.

Dargestellt ist weiterhin eine weitere Kurve 30. Die Kurve 30 verbindet den Impedanzverlauf P₁ für die maximal mögliche Leistung mit dem Impedanzverlauf E₁ für die maximal mögliche Effizienz.

Auf der Kurve 30 liegen für verschiedene Zielleistungen verschiedene Impedanzzielwerte, wobei für jeden Impedanzzielwert der HF-Generator 60 eine Zielleistung bereitstellt, für die die Effizienz das jeweilige Maximum aufweist. Benötigt der Benutzer eine Leistung von P = 44,5 dBm, so bewegt er sich entlang der Kurve 30 bis zu der gewünschten Zielleistung. Für diese Zielleistung ist ein entsprechender Impedanzzielwert hinterlegt für den die Effizienz ihr Maximum hat. Dieser Impedanzzielwert wird dann durch die Impedanzanpassungsschaltung 50 eingestellt.

Grundsätzlich könnte auch eine Kurvenschar eingezeichnet werden, wobei die jeweiligen Impedanzzielwerte dann eine Effizienz ergeben, die vorzugsweise höchstens um 10 % von ihrem Maximum entfernt ist. Der Einsatz einer Kurvenschar hätte dann Vorteile, weil beispielsweise Impedanzzielwerte verwendet werden können, die eine minimale mechanische Verstellung der Impedanzanpassungsschaltung 50 erfordern.

Vorzugsweise ist die Kurve 30, also der Zusammenhang zwischen Zielleistung, Impedanzzielwerten und optional der Effizienz in der Look-Up-Tabelle 9 hinterlegt. Es ist außerdem klar, dass für unterschiedliche Betriebsfrequenzen des HF-Generators 60 unterschiedliche Verläufe der Kurve 30 vorliegen können.

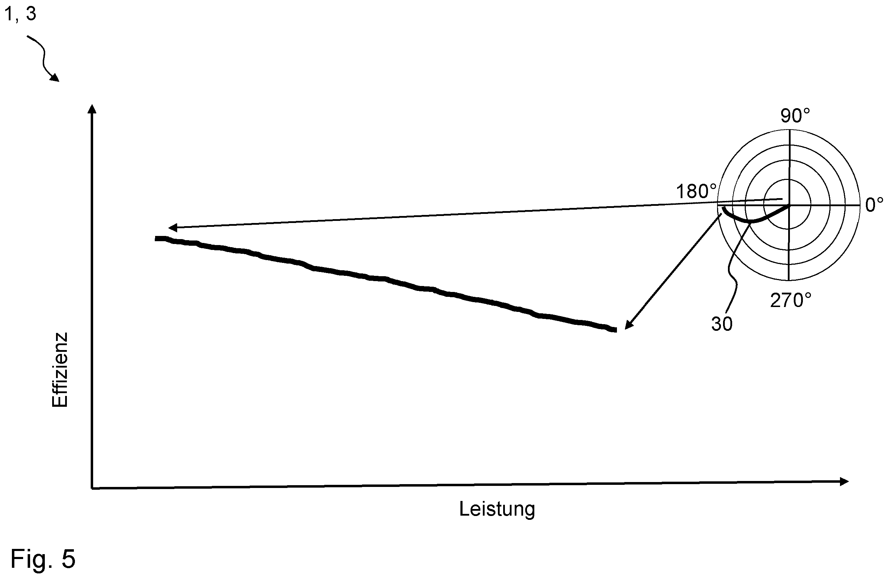

Figur 5 zeigt ein Diagramm, welches einen Verlauf der Effizienz für bestimmte Zielleistungen im Zusammenhang mit den notwendigen Impedanzzielwerten darstellt. Zu erkennen ist, dass für zunehmende Zielleistungen die Effizienz abnimmt. Ebenfalls ist dargestellt, für welche Impedanzzielwerte welche Effizienz bzw. welche Zielleistung erreichbar ist. Hierzu ist die Kurve 30 noch in Figur 5 eingezeichnet, wobei ein erstes Ende der Kurve 30 mit einer maximalen Effizienz einhergeht und wobei ein zweites Ende der Kurve 30 mit einer maximalen Leistung einhergeht.

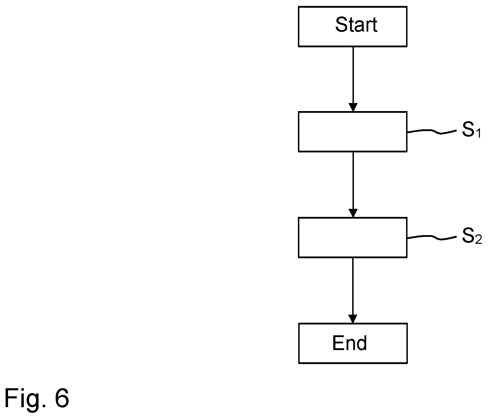

Figur 6 zeigt ein Flussdiagramm, welches ein Verfahren zur Ansteuerung der Impedanzanpassungsschaltung 50 beschreibt. In dem Verfahrensschritt S₁ wird ein Impedanzzielwert für den Eingangsanschluss 50a der Impedanzanpassungsschaltung 50 anhand einer vorgebbaren Betriebsfrequenz des HF-Generators 60, einer vorgebbaren Zielleistung des HF-Generators 60 und anhand von Modellparametern des HF-Generators 60 ermittelt. Der Impedanzzielwert weicht dabei von einer Nennimpedanz ab, um dadurch einen Betriebskennwert des HF-Generators 60 zu erhöhen, insbesondere um dadurch die Effizienz des HF-Generators 60 zu erhöhen. In dem Verfahrensschritt S₂ wird der ermittelte Impedanzzielwert durch die Impedanzanpassungsschaltung 50 eingestellt.

Die Erfindung ist nicht auf die beschriebenen Ausführungsbeispiele beschränkt. Im Rahmen der Erfindung sind alle beschriebenen und/oder gezeichneten Merkmale beliebig miteinander kombinierbar. Die Erfindung ist durch die Ansprüche definiert.

## Patentansprüche

1. Steuerungsvorrichtung (1) zur Ansteuerung einer Impedanzanpassungsschaltung (50) für ein Plasmaerzeugungssystem (100) mit einem Eingangsanschluss (50a) und einem Ausgangsanschluss (50b), zum Anschluss zwischen einem HF-Generator (60) und einer Last (70) **dadurch gekennzeichnet, dass**
die Steuerungsvorrichtung (1) dazu ausgebildet ist, um anhand von:
a) einer vorgebbaren Betriebsfrequenz des HF-Generators (60);
b) einer vorgegebenen Zielleistung des HF-Generators (60); und
c) Modelparametern des HF-Generators (60);
einen Impedanzzielwert für den Eingangsanschluss (50a) der Impedanzanpassungsschaltung (50) zu ermitteln, wobei der Impedanzzielwert einen von der Nennimpedanz abweichenden Wert aufweist, um eine Erhöhung eines Betriebskennwerts des HF-Generators (60), insbesondere der Effizienz, für die vorgebbare Betriebsfrequenz und die vorgebbare Zielleistung zu erreichen.

2. Steuerungsvorrichtung (1) nach Anspruch 1, mit den folgenden Merkmalen:
- der Betriebskennwert umfasst eine oder mehrere der folgenden Eigenschaften des HF-Generators (60):
a) Effizienz;
b) Temperatur, insbesondere die Begrenzung auf eine maximal zulässige Temperatur, in bestimmten Bauteilen, z.B. Transistoren, Kapazitäten, Induktivitäten, Kopplern, Anpassungsschaltungen;
c) Spannung, insbesondere die Begrenzung auf eine maximal zulässige Spannung, in bestimmten Bauteilen, z.B. Transistoren, Kapazitäten, Induktivitäten, Kopplern, Anpassungsschaltungen;
d) Strom, Spannungen, insbesondere die Begrenzung auf einen maximal zulässigen Strom, in bestimmten Bauteilen, z.B. Transistoren, Kapazitäten, Induktivitäten, Kopplern, Anpassungsschaltungen.

3. Steuerungsvorrichtung (1) nach einem der vorherigen Ansprüche, mit dem folgenden Merkmal:
- die Modellparameter des HF-Generators (60) umfassen für verschiedene vorgebbare Zielleistungen dazu korrespondierende Impedanzzielwerte, für welche die Effizienz ihr Maximum erreicht oder höchstens um 10% von ihrem Maximum entfernt ist.

4. Steuerungsvorrichtung (1) nach einem der vorherigen Ansprüche, mit dem folgenden Merkmal:
- die Steuerungsvorrichtung (1) ist dazu ausgebildet, um zusätzlich die Modellparameter einer Kabelimpedanz einer Kabelverbindung (2a) zwischen dem HF-Generator (60) und der Impedanzanpassungsschaltung (50) zu berücksichtigen.

5. Steuerungsvorrichtung (1) nach einem der vorherigen Ansprüche, mit dem folgenden Merkmal:
- die Steuerungsvorrichtung (1) ist dazu ausgebildet, um zusätzlich die Modellparameter der Impedanzanpassungsschaltung (50) zu berücksichtigen.

6. Steuerungsvorrichtung (1) nach einem der vorherigen Ansprüche, mit dem folgenden Merkmal:
- Steuerungsvorrichtung (1) ist dazu ausgebildet, um bei einem gepulsten Betrieb des HF-Generators (60), in dem Pulse mit unterschiedlicher Amplitude erzeugt werden, für die unterschiedlichen Pulse unterschiedliche Impedanzzielwerte für den Eingangsanschluss (50a) der Impedanzanpassungsschaltung (50) zu ermitteln.

7. Steuerungsvorrichtung (1) nach einem der vorherigen Ansprüche, mit dem folgenden Merkmal:
- die Steuerungsvorrichtung (1) ist dazu ausgebildet, um Impedanzzielwerte für den Eingangsanschluss (50a) der Impedanzanpassungsschaltung (50) zu ermitteln, wobei die Impedanzzielwerte derart gewählt sind, dass der HF-Generator (60) eine entsprechende Zielleistung für die gesamte Hüllkurve eines erzeugten Signals bereitstellen kann.

8. Plasmaerzeugungssystem (100) mit einer Steuerungsvorrichtung (1) gemäß einem der vorherigen Ansprüche, einem HF-Generator (60) und einer Impedanzanpassungsschaltung (50), wobei ein Ausgangsanschluss (60a) des HF-Generators (60) mit dem Eingangsanschluss (50a) der Impedanzanpassungsschaltung (50) verbunden ist.

9. Plasmaerzeugungssystem (100) nach Anspruch 8, mit dem folgenden Merkmal:
- die Steuerungsvorrichtung (1) ist dazu ausgebildet, um bei Ermittlung des Impedanzzielwerts am Eingangsanschluss (50a) der Impedanzanpassungsschaltung (50) die Kabelimpedanz der Kabelverbindung (2a) zwischen dem HF-Generator (60) und der Impedanzanpassungsschaltung (50) zu berücksichtigen.

10. Plasmaerzeugungssystem (100) nach Anspruch 9, mit dem folgenden Merkmal:
- die Steuerungsvorrichtung (1) ist dazu ausgebildet, um die Kabelimpedanz der Kabelverbindung (2a) zwischen dem HF-Generator (60) und der Impedanzanpassungsschaltung (50) zu berücksichtigen und im Betrieb des Plasmaerzeugungssystems (100) fortlaufend neu zu bestimmen.

11. Plasmaerzeugungssystem (100) nach einem der Ansprüche 8 bis 10, mit den folgenden Merkmalen:
- es sind eine erste und eine zweite Messeinheit (5, 6) vorgesehen;
- die Steuerungsvorrichtung (1) ist dazu ausgebildet, um die Kabelimpedanz der Kabelverbindung (2a) mittels der ersten und der zweiten Messeinheit (5, 6) zu berechnen, wobei die erste Messeinheit (5):
a) zwischen HF-Generator (60) und der Kabelverbindung (2a); und/oder
b) im Bereich des Ausgangsanschlusses (60a) des HF-Generators (60) angeordnet ist; und
wobei die zweite Messeinheit (6):
a) zwischen der Kabelverbindung (2a) und der Impedanzanpassungsschaltung (50) und/oder im Bereich des Eingangsanschlusses (50a) der Impedanzanpassungsschaltung (50); oder
b) zwischen der Impedanzanpassungsschaltung (50) und der Last (70) angeordnet ist.

12. Plasmaerzeugungssystem (100) nach Anspruch 11, mit den folgenden Merkmalen:
- die erste Messeinheit (5) weist einen Richtkoppler und/oder die zweite Messeinheit (6) weist einen Richtkoppler auf; und/oder
- die erste Messeinheit (5) umfasst einen Stromsensor (15) und einen Spannungssensor (16) und/oder die zweite Messeinheit (6) umfasst einen Stromsensor (15) und einen Spannungssensor (16).

13. Plasmaerzeugungssystem (100) nach Anspruch 12, mit den folgenden Merkmalen:
- der Spannungssensor (16) der ersten Messeinheit (5) weist einen kapazitiven Spannungsteiler auf, wobei eine erste Kapazität durch einen elektrisch leitfähigen Ring (19) oder Zylinder gebildet ist, durch den die Kabelverbindung (2a) im Bereich des Ausgangsanschlusses (60a) des HF-Generators (60) und der Impedanzanpassungsschaltung (50) geführt ist;
und
- der Stromsensor (15) der ersten Messeinheit (5) weist eine Spule auf, die um den leitfähigen Ring (16) oder Zylinder herum angeordnet ist;
und/oder
- der Spannungssensor (16) der zweiten Messeinheit (6) weist einen kapazitiven Spannungsteiler auf, wobei eine erste Kapazität durch einen elektrisch leitfähigen Ring (19) oder Zylinder gebildet ist, durch den die:
a) Kabelverbindung (2a) im Bereich des Eingangsanschlusses (50a) der Impedanzanpassungsschaltung (50) geführt ist; oder
b) Kabelverbindung (2b) zwischen der Impedanzanpassungsschaltung (50) und der Last (70) geführt ist;
und
- der Stromsensor der zweiten Messeinheit (6) weist eine Spule auf, die um den leitfähigen Ring (19) oder Zylinder herum angeordnet ist.

14. Plasmaerzeugungssystem (100) nach einem der Ansprüche 8 bis 13, mit dem folgenden Merkmal:
- die Steuerungsvorrichtung (1) ist dazu ausgebildet, um die Leistung des HF-Generators (60) zu verändern, wobei dies durch eine Änderung einer Eingangsleistung eines Verstärkers des HF-Generators (60) und/oder durch Änderung einer Versorgungsspannung eines Verstärkers des HF-Generators (60) erfolgt.

15. Verfahren zur Ansteuerung einer Impedanzanpassungsschaltung (50)für ein Plasmaerzeugungssystem (100) aufweisend einen Eingangsanschluss (50a), der mit dem Ausgangsanschluss (60a) eines HF-Generators (60) verbunden ist, und einem Ausgangsanschluss (50b), der mit dem Eingang einer Last (70) verbunden ist, wobei das Verfahren geeignet ist zum Einstellen der Eingangs-Impedanz am Eingangsanschluss (50a) bei veränderlicher Ausgangs-Impedanz am Ausgangsanschluss (50b), **dadurch gekennzeichnet, dass** das Verfahren den folgenden Verfahrensschritt aufweist:
- Ermitteln eines Impedanzzielwerts für den Eingangsanschluss (50a) anhand von:
a) einer vorgebbaren Betriebsfrequenz des HF-Generators (60);
b) einer vorgegebenen Zielleistung des HF-Generators; (60) und
c) Modelparametern des HF-Generators (60);
wobei der Impedanzzielwert einen von der Nennimpedanz abweichenden Wert aufweist, um eine Erhöhung eines Betriebskennwerts des HF-Generators (60), insbesondere der Effizienz, für die vorgebbare Betriebsfrequenz und die vorgebbare Zielleistung zu erreichen.

## Claims

1. A control device (1) for actuating an impedance matching circuit (50) for a plasma generation system (100), with an input terminal (50a) and an output terminal (50b) for connection between an RF generator (60) and a load (70), **characterized in that** the control device (1) is designed, on the basis of:
a) a predefinable operating frequency of the RF generator (60);
b) a predefined target power of the RF generator (60); and
c) model parameters of the RF generator (60);
to ascertain a target impedance value for the input terminal (50a) of the impedance matching circuit (50), wherein the target impedance value has a value that deviates from the nominal impedance in order to achieve an increase in a characteristic operating value of the RF generator (60), in particular the efficiency, for the predefinable operating frequency and the predefinable target power.

2. The control device (1) according to claim 1, with the following features:
- the characteristic operating value includes one or more of the following characteristics of the RF generator (60):
a) efficiency;
b) temperature, in particular the limitation to a maximum permissible temperature, in certain components, for example transistors, capacitors, inductors, couplers, matching circuits;
c) voltage, in particular the limitation to a maximum permissible voltage, in certain components, for example transistors, capacitors, inductors, couplers, matching circuits;
d) current, voltages, in particular the limitation to a maximum permissible current, in certain components, for example transistors, capacitors, inductors, couplers, matching circuits.

3. The control device (1) according to any one of the previous claims, with the following feature:
- for different predefinable target powers, the model parameters of the RF generator (60) include corresponding target impedance values for which the efficiency reaches its maximum or is at most 10% away from its maximum.

4. The control device (1) according to any one of the previous claims, with the following feature:
- the control device (1) is designed, in addition, to take the model parameters of a cable impedance of a cable connection (2a) between the RF generator (60) and the impedance matching circuit (50) into account.

5. The control device (1) according to any one of the previous claims, with the following feature:
- the control device (1) is designed, in addition, to take the model parameters of the impedance matching circuit (50) into account.

6. The control device (1) according to any one of the previous claims, with the following feature:
- the control device (1) is designed, in a pulsed operation of the RF generator (60) in which pulses of different amplitudes are generated, to ascertain, for the different pulses, different target impedance values for the input terminal (50a) of the impedance matching circuit (50).

7. The control device (1) according to any one of the previous claims, with the following feature:
- the control device (1) is designed to ascertain target impedance values for the input terminal (50a) of the impedance matching circuit (50), wherein the target impedance values are selected such that the RF generator (60) can provide a corresponding target power for the entire envelope of a generated signal.

8. A plasma generation system (100) with a control device (1) according to any one of the previous claims, an RF generator (60) and an impedance matching circuit (50), wherein an output terminal (60a) of the RF generator (60) is connected to the input terminal (50a) of the impedance matching circuit (50).

9. The plasma generation system (100) according to claim 8, with the following feature:
- the control device (1) is designed to take the cable impedance of the cable connection (2a) between the RF generator (60) and the impedance matching circuit (50) into account when the target impedance value at the input terminal (50a) of the impedance matching circuit (50) is ascertained.

10. The plasma generation system (100) according to claim 9, with the following feature:
- the control device (1) is designed to take the cable impedance of the cable connection (2a) between the RF generator (60) and the impedance matching circuit (50) into account and to continuously re-determine it during operation of the plasma generation system (100).

11. The plasma generation system (100) according any one of claims 8 to 10, with the following features:
- a first and a second measuring unit (5, 6) are provided;
- the control device (1) is designed to calculate the cable impedance of the cable connection (2a) by means of the first and the second measuring unit (5, 6), wherein the first measuring unit (5) is arranged:
a) between the RF generator (60) and the cable connection (2a); and/or
b) in the region of the outlet terminal (60a) of the RF generator (60); and
wherein the second measuring unit (6) is arranged:
a) between the cable connection (2a) and the impedance matching circuit (50) and/or in the region of the input terminal (50a) of the impedance matching circuit (50); or
b) between the impedance matching circuit (50) and the load (70).

12. The plasma generation system (100) according to claim 11, with the following features:
- the first measuring unit (5) has a directional coupler and/or the second measuring unit (6) has a directional coupler; and/or
- the first measuring unit (5) includes a current sensor (15) and a voltage sensor (16) and/or the second measuring unit (6) includes a current sensor (15) and a voltage sensor (16).

13. The plasma generation system (100) according to claim 12, with the following features:
- the voltage sensor (16) of the first measuring unit (5) has a capacitive voltage divider, wherein a first capacitance is formed by an electrically conductive ring (19) or cylinder through which the cable connection (2a) is routed in the region of the output terminal (60a) of the RF generator (60) and the impedance matching circuit (50);
and
- the current sensor (15) of the first measuring unit (5) has a coil arranged around the conductive ring (16) or cylinder;
and/or
- the voltage sensor (16) of the second measuring unit (6) has a capacitive voltage divider, wherein a first capacitance is formed by an electrically conductive ring (19) or cylinder, through which:
a) the cable connection (2a) is routed in the region of the input terminal (50a) of the impedance matching circuit (50); or
b) the cable connection (2b) is routed between the impedance matching circuit (50) and the load (70);
and
- the current sensor of the second measuring unit (6) has a coil arranged around the conductive ring (19) or cylinder.

14. The plasma generation system (100) according to any one of claims 8 to 13, with the following feature:
- the control device (1) is designed to change the power of the RF generator (60), wherein this takes place due to a change in an input power of an amplifier of the RF generator (60) and/or due to a change in a supply voltage of an amplifier of the RF generator (60).

15. A method for actuating an impedance matching circuit (50) for a plasma generation system (100), said circuit having an input terminal (50a) connected to an output terminal (60a) of an RF generator (60) and an output terminal (50b) connected to an input of a load (70), wherein the method is suitable for adjusting the input impedance at the input terminal (50a) when the output impedance at the output terminal (50b) changes, **characterized in that** the method has the following method step:
- ascertaining a target impedance value for the input terminal (50a) on the basis of:
a) a predefinable operating frequency of the RF generator (60);
b) a predefined target power of the RF generator (60); and
c) model parameters of the RF generator (60);
wherein the target impedance value has a value that deviates from the nominal impedance in order to achieve an increase in a characteristic operating value of the RF generator (60), in particular the efficiency, for the predefinable operating frequency and the predefinable target power.

## Revendications

1. Dispositif de commande (1) pour la commande d'un circuit d'adaptation d'impédance (50) pour un système de génération de plasma (100) comportant une borne d'entrée (50a) et une borne de sortie (50b), destiné à être raccordé entre un générateur HF (60) et une charge (70), **caractérisé en ce que**
le dispositif de commande (1) est conçu pour déterminer, sur la base :
a) d'une fréquence de fonctionnement prédéfinissable du générateur HF (60) ;
b) d'une puissance cible prédéfinie du générateur HF (60) ; et
c) de paramètres de modèle du générateur HF (60) ;
une valeur cible d'impédance pour la borne d'entrée (50a) du circuit d'adaptation d'impédance (50), dans lequel la valeur cible d'impédance présente une valeur déviant de l'impédance nominale, afin d'obtenir une augmentation d'un paramètre de fonctionnement du générateur HF (60), en particulier du rendement, pour la fréquence de fonctionnement prédéfinissable et la puissance cible prédéfinissable.

2. Dispositif de commande (1) selon la revendication 1, présentant les caractéristiques suivantes :
- le paramètre de fonctionnement comprend une ou plusieurs des propriétés suivantes du générateur HF (60) :
a) rendement ;
b) température, en particulier la limitation à une température maximale admissible, dans certains composants, par exemple transistors, capacités, inductances, coupleurs, circuits d'adaptation ;
c) tension, en particulier la limitation à une tension maximale admissible, dans certains composants, par exemple transistors, capacités, inductances, coupleurs, circuits d'adaptation ;
d) courant, tensions, en particulier la limitation à un courant maximal admissible, dans certains composants, par exemple transistors, capacités, inductances, coupleurs, circuits d'adaptation.

3. Dispositif de commande (1) selon l'une quelconque des revendications précédentes, présentant la caractéristique suivante :
- les paramètres de modèle du générateur HF (60) comprennent, pour différentes puissances cibles prédéfinissables, des valeurs cibles d'impédance correspondantes, pour lesquelles le rendement atteint son maximum ou s'écarte d'au plus 10 % de son maximum.

4. Dispositif de commande (1) selon l'une quelconque des revendications précédentes, présentant la caractéristique suivante :
- le dispositif de commande (1) est conçu pour prendre également en compte les paramètres de modèle d'une impédance de câble d'une liaison par câble (2a) entre le générateur HF (60) et le circuit d'adaptation d'impédance (50).

5. Dispositif de commande (1) selon l'une quelconque des revendications précédentes, présentant la caractéristique suivante :
- le dispositif de commande (1) est conçu pour prendre également en compte les paramètres de modèle du circuit d'adaptation d'impédance (50).

6. Dispositif de commande (1) selon l'une quelconque des revendications précédentes, présentant la caractéristique suivante :
- le dispositif de commande (1) est conçu pour déterminer, dans un fonctionnement pulsé du générateur HF (60), dans lequel des impulsions de différentes amplitudes sont générées, pour les différentes impulsions des valeurs cibles d'impédance différentes pour la borne d'entrée (50a) du circuit d'adaptation d'impédance (50).

7. Dispositif de commande (1) selon l'une quelconque des revendications précédentes, présentant la caractéristique suivante :
- le dispositif de commande (1) est conçu pour déterminer des valeurs cibles d'impédance pour la borne d'entrée (50a) du circuit d'adaptation d'impédance (50), dans lequel les valeurs cibles d'impédance sont choisies de telle sorte que le générateur HF (60) puisse fournir une puissance cible correspondante pour l'ensemble de l'enveloppe du signal généré.

8. Système de génération de plasma (100) comportant un dispositif de commande (1) selon l'une quelconque des revendications précédentes, un générateur HF (60) et un circuit d'adaptation d'impédance (50), dans lequel une borne de sortie (60a) du générateur HF (60) est reliée à la borne d'entrée (50a) du circuit d'adaptation d'impédance (50).

9. Système de génération de plasma (100) selon la revendication 8, présentant la caractéristique suivante :
- le dispositif de commande (1) est conçu pour prendre en compte, lors de la détermination de la valeur cible d'impédance à la borne d'entrée (50a) du circuit d'adaptation d'impédance (50), l'impédance de câble de la liaison par câble (2a) entre le générateur HF (60) et le circuit d'adaptation d'impédance (50).

10. Système de génération de plasma (100) selon la revendication 9, présentant la caractéristique suivante :
- le dispositif de commande (1) est conçu pour prendre en compte l'impédance de câble de la liaison par câble (2a) entre le générateur HF (60) et le circuit d'adaptation d'impédance (50) et pour la déterminer à nouveau de manière continue durant le fonctionnement du système de génération de plasma (100).

11. Système de génération de plasma (100) selon l'une des revendications 8 à 10, présentant les caractéristiques suivantes :
- une première et une deuxième unité de mesure (5, 6) sont prévues ;
- le dispositif de commande (1) est conçu pour calculer l'impédance de câble de la liaison par câble (2a) au moyen de la première et de la deuxième unité de mesure (5, 6), dans lequel la première unité de mesure (5) est disposée :
a) entre le générateur HF (60) et la liaison par câble (2a) ; et/ou
b) dans la zone de la borne de sortie (60a) du générateur HF (60) ; et
dans lequel la deuxième unité de mesure (6) est disposée :
a) entre la liaison par câble (2a) et le circuit d'adaptation d'impédance (50) et/ou dans la zone de la borne d'entrée (50a) du circuit d'adaptation d'impédance (50) ; ou
b) entre le circuit d'adaptation d'impédance (50) et la charge (70).

12. Système de génération de plasma (100) selon la revendication 11, présentant les caractéristiques suivantes :
- la première unité de mesure (5) présente un coupleur directionnel et/ou la deuxième unité de mesure (6) présente un coupleur directionnel ; et/ou
- la première unité de mesure (5) comprend un capteur de courant (15) et un capteur de tension (16) et/ou la deuxième unité de mesure (6) comprend un capteur de courant (15) et un capteur de tension (16).

13. Système de génération de plasma (100) selon la revendication 12, présentant les caractéristiques suivantes :
- le capteur de tension (16) de la première unité de mesure (5) présente un diviseur de tension capacitif, dans lequel une première capacité est formée par un anneau (19) ou un cylindre conducteur, à travers lequel la liaison par câble (2a) est guidée dans la zone de la borne de sortie (60a) du générateur HF (60) et du circuit d'adaptation d'impédance (50) ;
et
- le capteur de courant (15) de la première unité de mesure (5) présente une bobine disposée autour de l'anneau (16) ou du cylindre conducteur ;
et/ou
- le capteur de tension (16) de la deuxième unité de mesure (6) présente un diviseur de tension capacitif, dans lequel une première capacité est formée par un anneau (19) ou un cylindre conducteur, à travers lequel :
a) la liaison par câble (2a) est guidée dans la zone de la borne d'entrée (50a) du circuit d'adaptation d'impédance (50) ; ou
b) la liaison par câble (2b) entre le circuit d'adaptation d'impédance (50) et la charge (70) est guidée ;
et
- le capteur de courant de la deuxième unité de mesure (6) présente une bobine disposée autour de l'anneau (19) ou du cylindre conducteur.

14. Système de génération de plasma (100) selon l'une des revendications 8 à 13, présentant la caractéristique suivante :
- le dispositif de commande (1) est conçu pour modifier la puissance du générateur HF (60), dans lequel ceci s'effectue par une modification d'une puissance d'entrée d'un amplificateur du générateur HF (60) et/ou par une modification d'une tension d'alimentation d'un amplificateur du générateur HF (60).

15. Procédé pour la commande d'un circuit d'adaptation d'impédance (50) pour un système de génération de plasma (100) présentant une borne d'entrée (50a), qui est reliée à la borne de sortie (60a) d'un générateur HF (60), et une borne de sortie (50b), qui est reliée à l'entrée d'une charge (70), dans lequel le procédé est adapté pour régler l'impédance d'entrée à la borne d'entrée (50a) en cas d'impédance de sortie variable à la borne de sortie (50b), **caractérisé en ce que** le procédé présente l'étape de procédé suivante :
- détermination d'une valeur cible d'impédance pour la borne d'entrée (50a) sur la base :
a) d'une fréquence de fonctionnement prédéfinissable du générateur HF (60) ;
b) d'une puissance cible prédéfinie du générateur HF (60) et
c) de paramètres de modèle du générateur HF (60) ;
dans lequel la valeur cible d'impédance présente une valeur déviant de l'impédance nominale, afin d'obtenir une augmentation d'un paramètre de fonctionnement du générateur HF (60), en particulier du rendement, pour la fréquence de fonctionnement prédéfinissable et la puissance cible prédéfinissable.
